# FASCICULE DE BREVET EUROPEEN

(11) **EP 3 259 710 B1**
(45) Date de publication et mention de la délivrance du brevet: **13.05.2020**
(21) Numéro de dépôt: 16712217.5
(22) Date de dépôt: 22.02.2016
(51) Int. Cl.: G06K 19/077, H01L 23/00, H01L 23/498

(54) **PROCEDE DE FABRICATION DE PONTS DIELECTRIQUES D'IDENTIFICATION SANS CONTACT**
VERFAHREN ZUR HERSTELLUNG KONTAKTLOSER DIELEKTRISCHER IDENTIFIKATIONSBRÜCKEN
METHOD FOR PRODUCING NON-CONTACT IDENTIFICATION DIELECTRIC BRIDGES

(30) Priorité: 20.02.2015 FR 1500324
(43) Date de publication de la demande: 27.12.2017
(73) Titulaire: Foucault, Jean Pierre, 75116 Paris (FR)
(72) Inventeur: Foucault, Jean Pierre, 75116 Paris (FR)
(74) Mandataire: Cabinet Camus Lebkiri
(86) Numéro de dépôt international: PCT/EP2016/053653
(87) Numéro de publication internationale: WO 2016/131985

(56) Documents cités:
- EP-A1- 2 045 034
- FR-A1- 2 795 203
- US-A1- 2004 192 011
- US-A1- 2005 001 785

## Description

L'invention concerne un procédé de fabrication d'étiquettes ou de tags RFID.

Les étiquettes ou tags en anglais RFID sont destinés à une identification par radiofréquence sans contact d'objets de formats très variés en remplacement des codes barres. Les étiquettes ou tags RFID sans contact comportent d'une part un circuit intégré nommé « chip » en anglais (puce) et un circuit conducteur formant antenne sur un support diélectrique. Les antennes sont en général en cuivre ou en aluminium mais peuvent être imprimées par des procédés d'impression tels que la sérigraphie (« screen printing » en anglais), le jet d'encre, la flexographie, etc... en utilisant des encres spéciales à base de composants conducteurs comme l'argent ou le cuivre. L'antenne est connectée au circuit intégré par l'intermédiaire de bornes nommées « pads » en anglais et ce pour assurer la réception et l'émission de signaux radiofréquences entre un lecteur distant (« reader » en anglais) et le circuit intégré.

La connexion des bornes du circuit conducteur formant antenne et des bornes du circuit intégré peut être réalisée suivant différentes méthodes. Les deux méthodes les plus couramment utilisées sont celle du câblage par fils ou « wire bonding » et celle par excroissances nommés « bumps » en anglais. Dans la méthode dite du « wire bonding », les bornes du circuit intégré sont connectées aux bornes du circuit conducteur (antenne) par l'intermédiaire de fils de connexion, très souvent en or. Ce qui entraine pour la connexion d'un circuit intégré à une antenne un minimum de quatre opérations de micro-soudage. L'ensemble est protégé par le dépôt d'une goutte de colle non conductrice. Les cadences de fabrication suivant ce procédé sont très faibles à cause des opérations de microsoudage. De plus, les circuits produits sont épais compte tenu du procédé de soudage.

La seconde méthode, la plus courante aujourd'hui, utilise des excroissances ou « bumps » positionnées aux quatre coins du circuit intégré de forme carrée ou rectangulaire. Les « bumps » sont en général en or pur à 99,9 %. La connexion est assurée après avoir retourné le circuit de 180 ° suivant la méthode dite de « flip-chip » de telle façon que les bumps se positionnent directement sur les pads du circuit conducteur. Un point de colle anisotropique disposé préalablement au retournement assure la connexion électrique unidirectionnelle entre les bumps du circuit intégré et les pads de l'antenne en même temps que la protection de la puce et des connexions par une couverture globale.

La tolérance au positionnement des circuits intégrés sur le support portant le circuit conducteur selon cette méthode est relativement faible et entraine une guerre commerciale entre les constructeurs de machines de positionnement et les fournisseurs de circuits intégrés avec comme conséquence une course technologique sur la qualité et sans doute une sur-qualité couteuse. Il s'en suit que la tolérance au positionnement varie de 30 µm chez les constructeurs de machines de positionnement à 50 µm chez les fournisseurs de circuits intégrés. S'agissant de circuits de toutes petites dimensions de l'ordre de 400 x 400 µm, la tolérance a toute son importance car les dimensions des bumps sont très faibles, 60 x 60 µm en général.

La conséquence de cette situation est que les machines utilisées pour le montage en « flip-chip » des circuits intégrés sur les circuits conducteurs sont relativement lentes et chères. Les cadences nominales les plus rapides sont de l'ordre de 10.000 unités par heure mais les cadences effectives sont très souvent inférieures à 8.000 pièces à l'heure. Pour pallier cette difficulté, les constructeurs de machines multiplient les têtes de pose, mais cette stratégie se fait au détriment du coût et également de la souplesse d'utilisation. Ces cadences sont très faibles en comparaison des cadences obtenues pour le montage de circuits montés en surface (CMS).

Le procédé en « flip-chip » est grevé par la manipulation délicate (retournement et positionnement) des circuits intégrés et leur positionnement dans le respect des tolérances imposées ainsi que par le procédé de fixation des circuits intégrés par l'utilisation de colle anisotropique couteuse à l'emploi et longue à sécher de l'ordre de 100 msec. imposant des tunnels de séchage couteux en investissement et en fonctionnement et encombrants.

Le document FR 2 795 203 intitulé « Module comportant au moins une puce et son interface de communication, objet comportant un module et procédé de réalisation desdits modules », le document EP 2 045 034 intitulé « Flip-chip mounting apparatus » et le document US 2004/192011 intitulé « Chip attachment in an RFID tag » sont connus de l'état de la technique.

Considérant l'art antérieur précité, un problème que se propose de résoudre l'invention est de réaliser un procédé de fabrication d'étiquettes RFID qui pallie aux inconvénients précités des procédés existants et qui autorise en particulier des cadences de report des circuits intégrés importantes en utilisant des machines dont les cadences de fabrication sont élevées avec des rendements et des budgets acceptables.

La solution proposée de l'invention à ce problème posé a pour premier objet un procédé de fabrication selon la revendication 1.

L'invention peut utiliser une machine de report dont les tolérances au positionnement des circuits intégrés sont comprises ou égales entre 30 et 50 µm avec une cadence nominale de l'ordre de 30.000 unités par heure. Le positionnement dans le respect des tolérances est assuré sur le support diélectrique par un module spécial intégré sous la machine de report utilisant pour la mise en place du circuit intégré les informations de repérage fournies par la machine de pose. Pour assurer un positionnement sans faille, la bobine du support diélectrique portant le circuit conducteur est alors arrêtée et immobile suivant un procédé de « stop and go » pour permettre à la pipette de la machine de pose de livrer le circuit intégré en respectant les tolérances et de maintenir ce circuit fixe en pression sur le support diélectrique pendant l'opération de fixation par laser. La bande du support diélectrique redémarre ensuite une fois la fixation par laser terminée. Le temps de fixation (« microbonding ») est estimé entre 1 et 2 msec. Aucun traitement thermique n'est nécessaire pendant et après cette opération. Les derniers développements des fabricants de circuits intégrés sont à l'élargissement des surfaces de contact soit en élargissant la surface des « pads » des circuits électriques par intégration de la zone de contact ayant un simple rôle fonctionnel de stabilisation de la puce et ne jouant aucun rôle dans la connexion du circuit intégré ou au contraire en remplaçant les « bumps » des circuits intégrés par une zone de contact élargie. Les tolérances de pose étant élargies, la vitesse de pose des circuits intégrés s'en trouve donc augmentée.

L'invention utilise un laser pour assurer la connexion du circuit intégré avec le circuit conducteur. Le laser est fixé en dessous de la machine de report et intégré dans un module spécial qui permet d'assurer le positionnement du circuit intégré sur le support diélectrique dans le respect des tolérances en même temps que le maintien par la pipette de dépose du circuit intégré en appliquant une légère pression de l'ordre d'un Newton. Le laser est déclenché dés que le circuit intégré est en place. Il est fait usage en fonction des circonstances d'un laser à une tête ou plusieurs têtes ou bien de plusieurs lasers fonctionnant simultanément dont les têtes sont orientées vers les surfaces de contact.

De manière avantageuse, la machine de report est une machine standard prévue pour le montage des composants montés en surface. Comme les circuits intégrés sont disposés dans la galette (« wafer ») avec leur face active orientée vers le haut, ceux-ci sont préalablement retournés avant leur saisie au moyen du bras de la pipette de préhension avant d'être disposés sur le support diélectrique.

Le laser peut fonctionner dans la gamme des lasers infra-rouge, comme par exemple une longueur d'onde de 1.064 nm. Cette gamme assure une bonne connexion des surfaces de contact qui si elles sont en alliage composé de plusieurs matériaux.

Elle a pour cinquième objet l'utilisation d'un laser fonctionnant dans la gamme des lasers verts, comme par exemple une longueur d'onde de 532 nm. Cette gamme assure une bonne connexion des surfaces de contact en métaux non ferreux comme le cuivre et l'or.

Le support en polyimide diélectrique résiste aux sollicitations des rayons laser et à la chaleur comme par exemple le Kapton® fourni par la société DuPont^{®}. De plus, et pour éviter les effets secondaires du rayonnement laser sur le support diélectrique, celui-ci pourra , si besoin est, être protégé entre le circuit conducteur et le support diélectrique par un revêtement anti-réfléchissant (« anti reflection coating ») dans le but de le neutraliser et de maitriser les rayons au moment de leur retour ou de leur dispersion non contrôlée.

Le pont diélectrique ou « strap » permet d'optimiser la fabrication des étiquettes ou tags RFID grâce à un format unique standardisé (norme JEDEC MO-283) du circuit conducteur utilisable pour plusieurs gammes de fréquences (seuls la longueur et le format varient alors que le pas et les tolérances restent identiques) dont celles les plus courantes comme la HF (High Frequency : 13,56 MHz) et la UHF (Ultra High Frequency : de 966 à 915 MHZ suivant les pays). Le pont électrique ou « strap » peut ensuite être reporté facilement de façon très rapide et fixé avec une colle conductrice standard compte tenu de la taille des surfaces en contact (de l'ordre de 3x3 mm) pour la fabrication des étiquettes ou tags RFID de formats et de spécification très différents.

L'invention sera mieux comprise à la lecture de la description non limitative qui va suivre, rédigée au regard des dessins annexés, dans lesquels :
La figure 1 illustre un mode de mise en œuvre du procédé de fabrication d'étiquettes RFID selon l'invention
La figure 2 schématise le report d'un circuit intégré sur un support portant un circuit conducteur formant antenne pour la fabrication de supports diélectriques ou straps sans contact selon l'invention
La figure 3 illustre le fonctionnement du laser pendant la fixation du circuit intégré sur le circuit conducteur.

Les étiquettes RFID ou tags selon l'invention sont de format très variable et répondent à des normes très précises comme par exemple la norme ISO 18000-3 pour les circuits HF (« High Frequency ») de fréquence 13,56 MHz et la norme ISO 18000-6 pour les circuits UHF (« Ultra High Frequency ») d'une fréquence de fonctionnement allant de 866 à 915 MHz. Ces étiquettes comportent un circuit intégré et un support d'un circuit conducteur formant antenne. Le circuit intégré ou puce se présente sous la forme d'un parallélépipède d'une centaine de microns d'épaisseur. A titre d'exemple, la puce la plus récente de NXP, la UCODE 7 mesure 120 µm d'épaisseur (± 15 µm). Les cotés sont de l'ordre de 400 µm. La face active de la puce comprend quatre « bumps » assurant les connexions. Dans le cas de la NXP UCODE 7, les « bumps » en or à 99,9 % ont une hauteur de 25 µm et mesurent 60 x 60 µm. Les « bumps » en or sont d'un grand intérêt pour assurer la liaison par soudage avec les « pads » du circuit conducteur en cuivre. Il s'agit d'une excellente possibilité offerte par l'utilisation d'un laser vert dont le coefficient d'absorption est excellent. Pour éviter les effets secondaires dus à l'utilisation de lasers verts, il est proposé de remplacer le substrat couramment utilisé dans l'industrie, à savoir le PET, par un matériau sensiblement identique au point de vue caractéristiques diélectriques mais résistant aux hautes températures, le polyimide comme le Kapton® fourni par la société DuPont®.

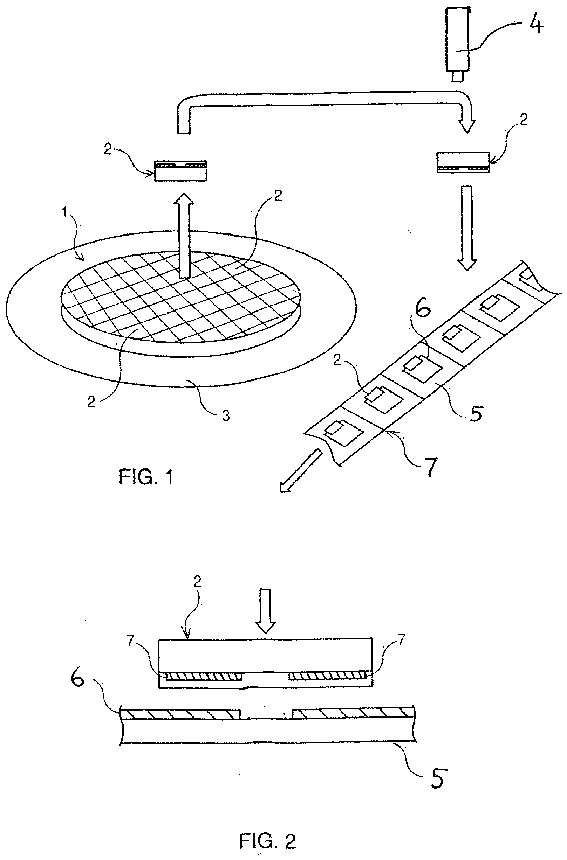

Les étapes de la fabrication des étiquettes ou tags RFID selon l'invention sont illustrées notamment à la figure 1.

Ainsi que cela apparait sur cette figure, pour la fabrication des étiquettes RFID, on fournit dans une première étape une galette 1 de silicium (« wafer » en anglais). Cette galette comprend une série de circuits intégrés 2 séparés les uns des autres par une étape préalable de sciage, de manière à ce que ceux-ci puissent être saisis au moyen d'un instrument de préhension d'une machine de report de circuits intégrés. La galette 1 sur laquelle sont positionnés les circuits intégrés avec leur face active orientée vers le haut repose sur un support 3 qui maintient en place les circuits intégrés. Les circuits intégrés défectueux sont identifiés, le plus souvent par marquage ou repérés dans une carte galette (« wafer map » en anglais) associée à la galette de façon à éliminer du traitement les circuits défectueux. Un système de préhension permet de saisir les circuits intégrés un par un à grande vitesse et de les amener après les avoir retournés. Le positionnement de ces circuits est repéré un par un par le système de vision 4.

Dans une autre étape du procédé selon l'invention, on fournit le support 5 en polyimide comme du Kapton™ de la société DuPont® sur lequel sont positionnés de façon régulière les circuits conducteurs 6 dont des bornes (« pads » en anglais) sont destinées à assurer une connexion aux plaques de contact (« bumps » ou « pads » en anglais) du circuit intégré par laser. En pratique, pour la fabrication des étiquettes RFID, les supports 5 sont fournis en bande 7 qui fera l'objet d'une découpe ultérieure.

On fournit enfin la machine de report. Cette machine comporte au moins un bras muni d'une pipette qui forme un moyen de préhension des circuits intégrés. Le moyen de préhension permet la saisie d'un circuit intégré, son retournement et son report sur le support 5 en polyimide.

Les circuits intégrés saisis et retournés sont amenés un à un à la verticale du circuit conducteur formant antenne pour être reportés entre les bornes du circuit conducteur. Lors de cette manipulation, le positionnement du circuit intégré est repéré par le système de vision 4.

L'étape de report est plus particulièrement schématisée à la figure 2. Ainsi que cela apparait sur cette figure, pour son report, le circuit intégré 2, muni des plaques de connexion 7 (« pads » en anglais) est amené à la verticale du support 5 portant l'antenne 6. Le positionnement du circuit intégré 2 dans le respect des tolérances de pose est assuré par le déplacement latéral et/ou longitudinal du support 5 par le module spécial intégré à la machine de report en fonction des données de repérage communiquées par le système de vision 4.

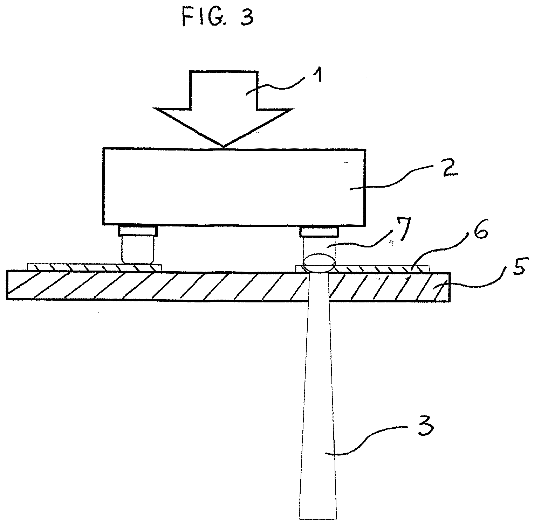

Ainsi que cela est illustré à la figure 3, le maintien du positionnement du circuit intégré par rapport au circuit conducteur est assuré par une pression adéquate de l'ordre de un Newton appliquée sur le circuit intégré par l'intermédiaire de la pipette de préhension 1 de la machine de report directement sur le circuit conducteur 6.

La connexion du circuit intégré au circuit conducteur formant antenne est assurée par un ou plusieurs faisceaux laser 3 suivant la configuration des étiquettes RFID. Le faisceau laser traverse le support en polyimide comme du Kapton™ de la société DuPont® pour souder avec la chaleur dégagée la surface de contact (« pad » en anglais) du circuit conducteur 6 à la surface de contact (« bump » ou « pad » en anglais) 7 du circuit intégré.

Le faisceau laser assure le micro-soudage (« micro-bonding » en anglais) avec une vitesse de l'ordre de un à deux millisecondes alors que le temps de séchage des adhésifs anisotropiques dans l'art antérieur est de l'ordre de 100 millisecondes. Il est associé à des coûts d'achat des machines inférieurs et des besoins en personnel identiques. Il en découle une très forte optimisation des coûts de production d'étiquettes RFID selon le procédé de l'invention.

L'utilisation de ponts diélectriques (« straps » en anglais) standard munis de bornes de connexion, ces bornes de connexion étant destinées à assurer une connexion à des surfaces de contact d'étiquettes RFID de format et de taille très variés permettent une fabrication très rationnelle sur une machine de façonnage pour répondre à des besoins très variés en fréquence (UHF ou HF), petites, moyennes ou grandes séries, supports particuliers pour répondre à des contraintes d'utilisation particulières, format spéciaux ou standard, etc...

Le procédé de fabrication suivant l'invention est destiné à une très grande généralisation de l'utilisation des étiquettes (tags en anglais) RFID à des prix abordables et répondant à des besoins très variés.

## Revendications

1. Procédé de fabrication de ponts diélectriques d'identification sans contact d'un pas standardisé et d'une tolérance élargie ou d'étiquettes de petite laize sans contact, le procédé comportant des étapes de :
- fourniture d'une galette (1) de silicium munie de circuits intégrés (2) standard face active tournée vers le haut préalablement préparée par sciage pour une connexion par laser (3) des surfaces de contact (7) des dits circuits intégrés (2) à des surfaces de contact de circuits conducteurs (6) disposés à la surface d'une bande support (5) diélectrique en polyimide résistant à la chaleur et aux rayonnements dispensés par laser;
- saisie des circuits intégrés (2) par l'intermédiaire d'un moyen de préhension d'une machine de report de circuits intégrés (2) assurant leur retournement à 180° ;
- saisie des informations de positionnement de chacun des circuits intégrés (2) par l'intermédiaire d'une d'un système de vision (4) assurant le repérage ;
- report des circuits intégrés (2) saisis sur la bande support (5) diélectrique en polyimide, de manière que les surfaces de contact (7) des circuits intégrés (2) soient positionnés en regard des surfaces de contact des circuits conducteurs (6) ;
- maintien par l'intermédiaire d'une légère pression du contact des surfaces de contact (7) des circuits intégrés (2) aux surfaces de contact des circuits conducteurs (6), la bande support (5) diélectrique étant immobilisée pendant cette opération ;
- connexion des circuits intégrés (2) avec les circuits conducteurs (6) par l'intermédiaire d'un laser (3) à une tête disposant d'un ou de plusieurs faisceaux ou de plusieurs têtes suivant la configuration et la taille des surfaces de contact, le ou les faisceaux traversant la bande support (5) diélectrique en polyimide pour souder avec la chaleur dégagée les surfaces de contact du circuit conducteur (6) aux surfaces de contact du circuit intégré (2) ;
- avancement d'un pas de la bande support (5) diélectrique pour assurer l'opération suivante.

2. Procédé selon la revendication 1, **caractérisé en ce que** la connexion des surfaces de contact des circuits intégrés (2) et des circuits conducteurs (6) est assurée par un laser de fréquence infrarouge, par exemple de 1.064 nm, à une ou plusieurs têtes notamment lorsque la composition des surfaces de contact est en alliage composé de plusieurs métaux.

3. Procédé selon la revendication 1, **caractérisé en ce que** la connexion des surfaces de contact des circuits intégrés (2) et des circuits conducteurs (6) est assurée par un laser (3) de fréquence vert, par exemple de 532 nm, à une ou plusieurs têtes notamment lorsque la composition des surfaces de contact est en métaux non ferreux.

4. Procédé selon la revendication 1, **caractérisé en ce que** les circuits conducteurs (2) forment une antenne et sont positionnés sur la bande support (5) en polymide résistant à la chaleur et aux faisceaux laser (3).

5. Procédé selon la revendication 1, **caractérisé en ce que** les circuits conducteurs (6) forment une antenne et sont positionnés sur la bande support (5) en polymide et sont protégés par un vernis anti réflexion fonction de la fréquence et de la puissance du laser (3) utilisé.

6. Procédé selon la revendication 1, **caractérisé en ce que** le report des circuits intégrés (2) sur les circuits conducteurs (6) est effectué suivant des tolérances de positionnement égales ou inférieures à 50 µm.

7. Procédé selon la revendication 1, **caractérisé en ce que** le report des circuits intégrés (2) sur les circuits conducteurs (6) est effectué à une cadence nominale de 30.000 unités par heure.

8. Procédé selon l'une des revendications précédentes, **caractérisé en ce que** la machine de report est une machine standard prévue pour le montage des composants en surface

9. Procédé selon l'une des revendications précédentes, **caractérisé en ce qu'**à la machine de report est intégré un module spécial sous la machine dont le fonctionnement est coordonné étroitement avec la machine de report et son système de vision (4).

10. Procédé selon l'une des revendications précédentes, **caractérisé en ce que** les circuits conducteurs (6) sont de petite taille et de préférence standardisés suivant la norme JEDEC MO-283.

## Patentansprüche

1. Herstellungsverfahren dielektrischer Identifizierungsbrücken ohne Kontakt eines genormten Schritts und einer erweiterten Toleranz oder kontaktloser Etiketten kleiner Breite, wobei das Verfahren Schritt umfasst:
- der Lieferung einer Standardsiliziumscheibe (1), die mit integrierten Schaltkreisen (2) versehen ist, deren aktive Seite nach oben gedreht ist, die zuvor per Sägen für einen Laseranschluss (3) der Kontaktflächen (7) der genannten integrierten Schaltkreise (2) mit Kontaktflächen von Leiter-Schaltkreisen (6) vorbereitet wurde, die auf der Fläche eines dielektrischen Trägerbandes (5) aus Polyimid angeordnet sind, das beständig gegen Wärme und die vom Laser ausgegebene Strahlung sind;
- das Ergreifen der integrierten Schaltkreise (2) mittels eines Greifmittels einer Verschiebungsmaschine integrierter Schaltkreise (2), die ihr Umdrehen um 180° gewährleisten;
- das Erfassen der Positionierungsinformationen jedes der integrierten Schaltkreise (2) mittels eines Sichtsystems (4), das die Kennzeichnung gewährleistet;
- Verschiebung der integrierten Schaltkreise (2), die auf dem dielektrischen Trägerband (5) aus Polyimid derart ergriffen werden, dass die Kontaktflächen (7) der integrierten Schaltkreise (2) gegenüber den Kontaktflächen der Leiter-Schaltkreise (6) positioniert sind;
- Festhalten des Kontaktes der Kontaktflächen (7) der integrierten Schaltkreise (2) auf den Kontaktflächen der Leiter-Schaltkreise (6) mittels eines leichten Drucks, wobei das dielektrische Trägerband (5) während dieser Operation blockiert ist;
- Anschluss der integrierten Schaltkreise (2) mit den Leiter-Schaltkreisen (6) mittel eines Lasers (3) mit einem Kopf, der über ein oder mehrere Strahlenbündel oder mehrere Köpfe gemäß der Ausgestaltung und der Größe der Kontaktflächen verfügt, wobei das oder die Strahlenbündel das dielektrische Trägerband (5) aus Polyimid zum Verschweißen mit der Wärme durchquert / durchqueren, die von den Kontaktflächen des Leiter-Schaltkreises (6) an die Kontaktflächen des integrierten Schaltkreises (2) abgegeben wird;
- Fortschreiten des dielektrischen Trägerbandes (5) um einen Schritt zum Gewährleisten der nachfolgenden Operation.

2. Verfahren gemäß Anspruch 1, **dadurch gekennzeichnet, dass** der Anschluss der Kontaktflächen der integrierten Schaltkreise (2) und der Leiter-Schaltkreise (6) durch einen Laser mit Infrarottrequenz, z. B. mit 1.064 nm, mit einem oder mehreren Köpfen gewährleistet wird, insbesondere, wenn die Zusammensetzung der Kontaktflächen aus einer Legierung ist, die sich aus mehreren Metallen zusammensetzt.

3. Verfahren gemäß Anspruch 1, **dadurch gekennzeichnet, dass** der Anschluss der Kontaktflächen der integrierten Schaltkreise (2) und der Leiter-Schaltkreise (6) durch einen Laser (3) mit grüner Frequenz, z. B. mit 532 nm, mit einem oder mehreren Köpfen gewährleistet wird, insbesondere, wenn die Zusammensetzung der Kontaktflächen aus nicht eisenhaltigen Metallen ist.

4. Verfahren gemäß Anspruch 1, **dadurch gekennzeichnet, dass** die Leiter-Schaltkreise (2) eine Antenne bilden und auf dem Trägerband (5) aus Polyimid positioniert sind, das gegen Wärme und Laserstrahlenbündel (3) beständig ist.

5. Verfahren gemäß Anspruch 1, **dadurch gekennzeichnet, dass** die Leiter-Schaltkreise (6) eine Antenne bilden und auf dem Trägerband (5) aus Polyimid positioniert sind und durch einen entspiegelten Lack in Abhängigkeit von der Frequenz und der Leistung des verwendeten Lasers (3) geschützt sind.

6. Verfahren gemäß Anspruch 1, **dadurch gekennzeichnet, dass** die Verschiebung der integrierten Schaltkreise (2) auf den Leiter-Schaltkreisen (6) gemäß Positionierungstoleranzen durchgeführt wird, die gleich oder niedriger als 50 µm sind.

7. Verfahren gemäß Anspruch 1, **dadurch gekennzeichnet, dass** die Verschiebung der integrierten Schaltkreise (2) auf den Leiter-Schaltkreisen (6) in einer nominalen Kadenz von 30.000 Einheiten pro Stunde durchgeführt wird.

8. Verfahren gemäß einem der voranstehenden Ansprüche, **dadurch gekennzeichnet, dass** die Verschiebungsmaschine eine Standardmaschine ist, die für die Montage der Bauteile auf der Fläche vorgesehen ist.

9. Verfahren gemäß einem der voranstehenden Ansprüche, **dadurch gekennzeichnet, dass** unter der Maschine ein Spezialmodul, dessen Funktionsweise eng mit der Verschiebungsmaschine und ihrem Sichtsystem (4) koordiniert ist, in die Maschine eingebaut ist.

10. Verfahren gemäß einem der voranstehenden Ansprüche, **dadurch gekennzeichnet, dass** die Leiter-Schaltkreise (6) von kleiner Größe und bevorzugt gemäß der Norm JEDEC MO-283 genormt sind.

## Claims

1. Method for the manufacturing of dielectric bridges for contactless identification, with a standardised pitch and with a broadened tolerance, or of contactless labels of small width, the method comprising steps of:
- provision of a standard silicon wafer (1) with integrated circuits (2) with the active face facing upwards, previously prepared by sawing, for a laser (3) connection of the contact pads (7) of said integrated circuits (2) to contact pads of conductive circuits (6) on the surface of a strip (5) of dielectric medium made of a polyimide which is resistant to heat and to the rays emitted by the lasers ;
- picking the integrated circuits (2) using a means for gripping of an integrated circuit (2) pick and place machine which flips them over;
- input of the integrated circuits (2) positioning data using a vision system (4) for location;
- placing of the picked integrated circuits (2) on to the strip (5) of dielectric medium made of polyimide, such that the contact pads (7) of the integrated circuits (2) are positioned facing the contact pads of the conductive circuits (6);
- held in place by a slight contact pressure of the contact pads (7) of the integrated circuits (2) on the contact pads of the conductive circuits (6), the strip (5) of dielectric medium being immobilised during this operation;
- connection of the integrated circuits (2) with the conductive circuits (6) using a laser (3) with one head and one or more beam(s), or with several heads, depending on the configuration and the size of the contact pads, the beam(s) passing through the strip (5) of dielectric medium, for soldering with the heat released the contact pads of the conductive circuit (6) with the contact pads of the integrated circuit (2);
- advance of one pitch of the strip (5) of dielectric medium to undertake the next operation.

2. Method according to claim 1, **characterised by** the fact that the contact pads of the integrated circuits (2) and of the conductive circuits (6) are connected by an infrared frequency laser, for example of 1,064 nm, with one or more heads, in particular when the composition of the contact pads is made of an alloy composed of several metals.

3. Method according to claim 1, **characterised by** the fact that the contact pads of the integrated circuits (2) and of the conductive circuits (6) are connected by a green frequency laser (3), for example of 532 nm, with one or more heads, in particular when the composition of the contact pads is made of non-ferrous metals.

4. Method according to claim 1, **characterised by** the fact that the conductive circuits (2) form an antenna and are positioned on the strip (5) made of polymide which is resistant to heat and to the laser (3) beams.

5. Method according to claim 1, **characterised by** the fact that the conductive circuits (6) form an antenna and are positioned on the strip (5) made of polymide and are protected by an anti-reflective coating, which depends on the frequency and power of the laser (3) used.

6. Method according to claim 1, **characterised by** the fact that the integrated circuits (2) are placed on the conductive circuits (6) with positioning tolerances equal to or less than 50 µm.

7. Method according to claim 1, **characterised by** the fact that the integrated circuits (2) are placed on the conductive circuits (6) with a nominal output of 30,000 units per hour.

8. Method according to any of the preceding claims, **characterised by** the fact that the pick and place machine is a standard machine for surface mounting of components.

9. Method according to any of the preceding claims, **characterised by** the fact that a special module is integrated under the pick and place machine, the operation of which is closely coordinated with the pick and place machine and its vision system (4).

10. Method according to any of the preceding claims, **characterised by** the fact that the conductive circuits (6) are small in size and preferably standardised according to the JEDEC MO-283 standard.
